# FASCICULE DE BREVET EUROPEEN

(11) **EP 3 465 788 B1**
(45) Date de publication et mention de la délivrance du brevet: **20.05.2020**
(21) Numéro de dépôt: 17732504.0
(22) Date de dépôt: 24.05.2017
(51) Int. Cl.: H01L 41/312

(54) **PROCEDE DE FABRICATION D'UNE COUCHE**
VERFAHREN ZUR HERSTELLUNG EINER SCHICHT
METHOD FOR PRODUCING A LAYER

(30) Priorité: 25.05.2016 FR 1654685
(43) Date de publication de la demande: 10.04.2019
(73) Titulaire: SOITEC, 38190 Bernin (FR)
(72) Inventeur: GHYSELEN, Bruno, 38170 Seyssinet-Parisnet (FR)
(74) Mandataire: Regimbeau
(86) Numéro de dépôt international: PCT/FR2017/051291
(87) Numéro de publication internationale: WO 2017/203174

(56) Documents cités:
- JP-A- H05 306 123
- US-A1- 2003 199 105
- US-A1- 2010 088 868

## Description

### DOMAINE DE L'INVENTION

La présente invention concerne un procédé de fabrication d'une couche de composition AA'BO₃ où A et A' sont constitués d'au moins un élément parmi : Li, Na, K, Ca, Mg, Ba, Sr, Pb, La, Bi, Y, Dy, Gd, Tb, Ce, Pr, Nd, Sm, Eu, Ho, Zr, Sc, Ag, Tl et B est constitué d'au moins un élément parmi : Nb, Ta, Sb, Ti, Zr, Sn, Ru, Fe, V, Sc, C, Ga, Al, Si, Mn, Zr, Tl, notamment piézoélectrique, en particulier pour une application à un dispositif microélectronique, photonique ou optique. En particulier mais de manière non limitative, ledit dispositif peut être un dispositif à ondes acoustiques de surface ou un dispositif à ondes acoustiques de volume pour applications radiofréquence.

### ARRIERE PLAN DE L'INVENTION

Parmi les composants acoustiques utilisés pour le filtrage dans le domaine radiofréquence, on distingue deux catégories principales de filtres :
- d'une part, les filtres à ondes acoustiques de surface, connus sous l'acronyme SAW (du terme anglo-saxon « Surface Acoustic Wave ») ;
- d'autre part, les filtres et résonateurs à ondes acoustiques de volume, connus sous l'acronyme BAW (du terme anglo-saxon « Bulk Acoustic Wave »).

Pour une revue de ces technologies, on pourra se référer à l'article de W. Steichen et S. Ballandras, « Composants acoustiques utilisés pour le filtrage - Revue des différentes technologies », Techniques de l'Ingénieur, E2000, 2008.

Les filtres à ondes acoustiques de surface comprennent typiquement une couche piézoélectrique épaisse (c'est-à-dire d'épaisseur généralement de plusieurs centaines de µm) et deux électrodes sous la forme de deux peignes métalliques interdigités déposés sur la surface de ladite couche piézoélectrique. Un signal électrique, typiquement une variation de tension électrique, appliqué à une électrode est converti en onde élastique qui se propage à la surface de la couche piézoélectrique. La propagation de cette onde élastique est favorisée si la fréquence de l'onde correspond à la bande de fréquence du filtre. Cette onde est à nouveau convertie en signal électrique en parvenant à l'autre électrode.

Les filtres à ondes acoustiques de volume comprennent quant à eux typiquement une couche piézoélectrique mince (c'est-à-dire d'épaisseur généralement sensiblement inférieure à 1 µm) et deux électrodes agencées sur chaque face principale de ladite couche mince. Un signal électrique, typiquement une variation de tension électrique, appliqué à une électrode est converti en onde élastique qui se propage au travers de la couche piézoélectrique. La propagation de cette onde élastique est favorisée si la fréquence de l'onde correspond à la bande de fréquence du filtre. Cette onde est à nouveau convertie en signal électrique en parvenant à l'électrode située sur la face opposée.

Dans le cas des filtres à ondes acoustiques de surface, la couche piézoélectrique doit présenter une excellente qualité cristalline pour ne pas engendrer d'atténuation de l'onde de surface. On préférera donc dans ce cas une couche monocristalline. A l'heure actuelle, les matériaux adéquats utilisables industriellement sont le quartz, le LiNbO₃ ou le LiTaO₃. La couche piézoélectrique est obtenue par découpe d'un lingot de l'un desdits matériaux, la précision requise pour l'épaisseur de ladite couche étant peu importante dans la mesure où les ondes doivent se propager essentiellement à sa surface.

Dans le cas des filtres à ondes acoustiques de volume, la couche piézoélectrique doit présenter une épaisseur déterminée et uniforme sur l'ensemble de la couche et ce, de manière précisément contrôlée. En revanche, la qualité cristalline passant au second plan des critères d'importance pour les performances du filtre, des compromis sont actuellement faits sur la qualité cristalline de ladite couche et une couche polycristalline a longtemps été considérée comme acceptable. La couche piézoélectrique est donc formée par dépôt sur un substrat support (par exemple un substrat de silicium). A l'heure actuelle, les matériaux employés industriellement pour un tel dépôt sont l'AIN, le ZnO et le Pb(Zr_{X},Ti_{1-X})O₃ (PZT).

Les choix de matériaux sont donc très limités dans les deux technologies.

Or, le choix d'un matériau résulte d'un compromis entre différentes propriétés du filtre, en fonction des spécifications du fabricant du filtre. En particulier, le coefficient de couplage électromécanique des matériaux piézoélectriques sont des critères de choix du matériau à utiliser pour une application donnée et une architecture de composant donnée.

Par exemple, le LiNbO₃ et le LiTaO₃ sont des matériaux fortement anisotropes. Le coefficient de couplage dépendant de l'orientation cristalline, le choix d'une orientation particulière du matériau offre un premier degré de liberté dans le choix du matériau. C'est la raison pour laquelle on peut trouver des substrats selon une multiplicité d'orientations cristallines, par exemple, et selon une terminologie anglo-saxonne : X-cut, Y-cut, Z-cut, YZ-cut, 36° rotated Y axis, 42° rotated Y axis, ...

Cependant, hormis la possibilité de sélectionner une orientation cristalline particulière, l'homme du métier ne dispose que du quartz, du LiNbO₃ et du LiTaO₃ pour concevoir un filtre à ondes acoustiques de surface, ce qui n'offre qu'une gamme limitée de paramètres pour optimiser les caractéristiques du filtre, même si quelques autres matériaux pourraient venir compléter cette liste à l'avenir comme le langasite La₃Ga₅SiO₁₄ par exemple.

Pour offrir davantage de liberté dans le dimensionnement des filtres à ondes acoustiques de volume ou des filtres à ondes acoustiques de surface, il serait souhaitable de pouvoir utiliser davantage de matériaux que les matériaux listés plus haut, sans nuire par ailleurs à la qualité des matériaux. Un exemple de l'art antérieur se trouve dans le brevet JP05-306123.

### BREVE DESCRIPTION DE L'INVENTION

Un but de l'invention est de remédier aux inconvénients précités et notamment de concevoir un procédé de fabrication d'une couche monocristalline, notamment piézoélectrique, en particulier pour un dispositif à ondes acoustiques de surface, en d'autres matériaux que les matériaux utilisés pour cette application, en particulier en permettant d'obtenir des couches minces (c'est-à-dire d'épaisseur inférieure à 20 µm, voire inférieure à 1 µm) et uniformes des matériaux utilisés pour les dispositifs à ondes acoustiques de surface. Par ailleurs, ce procédé doit également permettre d'utiliser une plus grande variété de substrats supports que dans les dispositifs à ondes acoustiques de volume existants.

Conformément à l'invention, il est proposé un procédé de fabrication d'une couche de composition AA'BO₃ où A est constitué d'au moins un élément parmi : Li, Na, K, Ca, Mg, Ba, Sr, Pb, La, Bi, Y, Dy, Gd, Tb, Ce, Pr, Nd, Sm, Eu, Ho, Zr, Sc, Ag, Tl et B est constitué d'au moins un élément parmi : Nb, Ta, Sb, Ti, Zr, Sn, Ru, Fe, V, Sc, C, Ga, Al, Si, Mn, Zr, Tl, caractérisé en ce qu'il comprend :
- la fourniture d'un substrat donneur de composition ABO₃,
- la formation d'une couche de composition ABO₃ par amincissement dudit substrat donneur,
- avant et/ou après l'étape d'amincissement, l'exposition de ladite couche de composition ABO₃ à un milieu contenant des ions d'un élément A' faisant partie de la même liste d'éléments que A, A' étant différent de A, de sorte à faire pénétrer lesdits ions dans ladite couche pour former une couche de composition AA'BO₃.

Par « substrat donneur de composition ABO₃ », on entend un substrat entièrement constitué de ABO₃ ou comprenant au moins une couche de ce matériau et dans laquelle peut être formée, par amincissement dudit substrat, une couche de composition ABO₃ destinée à être convertie en la couche de composition AA'BO₃.

Dans le cas où A est constitué de deux éléments ou davantage, on désigne par extension « élément A » l'ensemble des éléments constituant A. Dans ce cas, l'expression « A' est différent de A » signifie que l'élément A' est différent de chacun des éléments constituant A.

De manière particulièrement avantageuse, les ions de l'élément A' pénètrent dans la couche par un mécanisme d'échange ionique.

Selon un mode de réalisation, le milieu contenant les ions de l'élément A' est un liquide et la couche est immergée dans un bain dudit liquide.

Par exemple, la couche de composition ABO₃ peut être immergée dans un bain comprenant une solution acide d'un sel comprenant l'élément A'.

Selon un autre mode de réalisation, le milieu contenant les ions de l'élément A' est en phase gazeuse et la couche est exposée audit gaz.

Selon un mode de réalisation, les ions de l'élément A' pénètrent dans la couche par implantation et un traitement thermique peut être mis en oeuvre pour faire diffuser lesdits ions dans ladite couche.

Selon un autre mode de réalisation, le milieu contenant les ions de l'élément A' est en phase solide, une couche dudit milieu étant déposée sur la couche de composition ABO₃.

De manière avantageuse, le procédé comprend au moins une étape de recuit pour favoriser la diffusion de l'élément A' du milieu vers la couche de composition ABO₃.

Selon une forme d'exécution de l'invention, la couche de composition ABO₃ est monocristalline.

Selon un mode de réalisation, l'amincissement du substrat donneur comprend l'application d'un substrat receveur sur le substrat donneur, la couche de composition ABO₃ étant à l'interface, et le transfert de ladite couche sur le substrat receveur.

L'application du substrat receveur peut comprendre le dépôt dudit substrat sur le substrat donneur.

De manière alternative, l'application du substrat receveur comprend le collage dudit substrat sur le substrat donneur.

L'épaisseur de la couche transférée sur le substrat receveur est avantageusement inférieure à 20 µm.

Selon une forme d'exécution particulière, on forme au moins une couche électriquement isolante et/ou au moins une couche électriquement conductrice à l'interface entre le substrat receveur et la couche.

Selon un mode de réalisation, l'épaisseur de la couche de composition ABO₃ est supérieure à 2 µm,de préférence supérieure à 20 µm, ladite couche étant autoportée à l'issue de l'amincissement du substrat donneur.

L'amincissement du substrat donneur peut comprendre les étapes suivantes :
- la formation d'une zone de fragilisation dans le substrat donneur de sorte à délimiter la couche de composition ABO₃,
- le détachement du substrat donneur le long de la zone de fragilisation.

Ladite zone de fragilisation est avantageusement formée par implantation ionique dans le substrat donneur.

Selon une forme d'exécution particulière, l'élément A est du lithium et l'élément A' est du sodium et/ou du potassium. L'élément B peut alors être avantageusement du niobium et/ou du tantale.

L'invention concerne également un procédé de fabrication d'un dispositif à ondes acoustiques de volume comprenant la formation d'électrodes sur deux faces principales opposées d'une couche piézoélectrique, caractérisé en ce qu'il comprend la fabrication de ladite couche piézoélectrique par un procédé tel que décrit ci-dessus.

L'invention concerne également un procédé de fabrication d'un dispositif à ondes acoustiques de surface, comprenant la formation de deux électrodes interdigitées sur la surface d'une couche piézoélectrique, caractérisé en ce qu'il comprend la fabrication de ladite couche piézoélectrique par un procédé tel que décrit plus haut.

### BREVE DESCRIPTION DES DESSINS

D'autres caractéristiques et avantages de l'invention ressortiront de la description détaillée qui va suivre, en référence aux dessins annexés sur lesquels :
- les figures 1A à 1F illustrent de manière schématique des étapes du procédé de fabrication d'une couche monocristalline de composition AA'BO₃ selon un mode de réalisation de l'invention,
- la figure 2 est une vue de principe en coupe d'un filtre à ondes acoustiques de surface,
- la figure 3 est une vue de principe en coupe d'un filtre à ondes acoustiques de volume.

Pour des raisons de lisibilité des figures, les éléments illustrés ne sont pas nécessairement représentés à l'échelle. Par ailleurs, les éléments désignés par les mêmes signes de référence sur différentes figures sont identiques.

### DESCRIPTION DETAILLEE DE MODES DE REALISATION DE L'INVENTION

D'une manière générale, on forme une couche de composition ABO₃ par amincissement d'un substrat donneur de composition ABO₃. Ledit amincissement peut être réalisé par toute technique appropriée, parmi lesquelles on peut citer le procédé Smart Cut™ grâce auquel on forme, par implantation d'espèces ioniques dans le substrat donneur, une zone de fragilisation délimitant la couche d'intérêt ; toute autre technique de formation de la zone de fragilisation pouvant être employée ; ou encore la mise en oeuvre d'une ou plusieurs étapes de gravure du substrat donneur de sorte à ne conserver que la couche d'intérêt.

Si la couche est suffisamment épaisse, elle peut être autoportée, c'est-à-dire qu'elle ne nécessite pas d'être appliquée sur un substrat raidisseur pour présenter une tenue mécanique suffisante.

De manière alternative, notamment si la couche est fine, l'amincissement du substrat donneur est précédé d'une étape d'application, sur le substrat donneur, d'un substrat receveur. L'application dudit substrat receveur peut se faire notamment par collage ou par dépôt sur le substrat donneur.

A partir de la couche de composition ABO₃ ainsi obtenue, on obtient une couche de composition plus complexe de type AA'BO₃, dans laquelle A' appartient à la même liste d'éléments que A mais est différent de A. L'obtention d'une telle couche suppose d'exposer la couche de composition ABO₃ à un milieu comprenant des ions de l'élément A', de sorte à faire pénétrer au moins une partie desdits ions dans la couche.

La conversion de la couche de composition initiale ABO₃ en une couche de composition AA'BO₃ fait avantageusement intervenir un mécanisme d'échange ionique qui est utilisé dans le domaine des verres. Par exemple, il est connu de remplacer une partie des ions Na+ présents dans certains verres par des ions Ag+ ou K+, en mettant en oeuvre un traitement consistant à immerger le verre dans un bain de sels fondus par exemple d'AgNO₃ ou de KNO₃, respectivement. De manière similaire, l'invention peut être mise en oeuvre en exposant la couche à convertir en une couche de composition plus complexe à un milieu contenant des ions de l'élément A' dont on souhaite enrichir ladite couche, ledit milieu pouvant être liquide (par exemple un bain d'une solution acide d'un sel comprenant l'élément A'), gazeux ou solide).

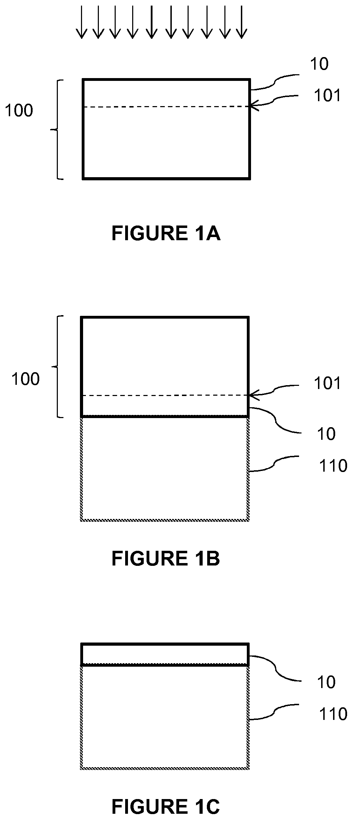

En référence aux figures 1A à 1D, on considère un procédé de fabrication d'une couche de composition AA'BO₃ selon un mode de réalisation mettant en oeuvre le procédé Smart Cut™, comprenant les étapes suivantes :
- la fourniture d'un substrat donneur de composition ABO₃,
- la formation d'une zone de fragilisation 101 par implantation d'espèces ioniques (par exemple de l'hydrogène et/ou de l'hélium) dans le substrat donneur 100 de sorte à délimiter la couche 10 à transférer (cf. figure 1A),
- l'application d'un substrat receveur 110 sur le substrat donneur 100, la couche 10 à transférer étant à l'interface (cf. figure 1B),
- le détachement du substrat donneur 100 le long de la zone de fragilisation 101 de sorte à transférer la couche 10 sur le substrat receveur 110 (cf. figure 1C).

De manière alternative (non illustrée) au procédé Smart Cut™, le transfert de la couche 10 sur le substrat receveur peut être effectué par un amincissement du substrat donneur 100 par sa face opposée à l'interface de collage, jusqu'à la couche 10 à transférer. Cet amincissement peut impliquer au moins une gravure, un polissage mécano-chimique et/ou toute autre technique appropriée.

Le substrat donneur peut être un substrat massif du matériau considéré. De manière alternative, le substrat donneur peut être un substrat composite, c'est-à-dire formé d'un empilement d'au moins deux couches de matériaux différents, dont une couche superficielle est constituée du matériau considéré.

Parmi les matériaux piézoélectriques d'intérêt particulier se trouvent les matériaux perovskites et assimilés, de structure ABO₃. Toutefois, l'intérêt que l'on peut porter à ces matériaux ne se limite pas à leur caractère piézoélectrique. Notamment pour d'autres applications, par exemple liées à l'optique intégrée, on pourra aussi s'y intéresser le cas échéant pour leur permittivité diélectrique, pour leurs indices de réfraction, ou encore pour leurs propriétés pyroélectriques, ferroélectriques ou encore ferromagnétiques par exemple et selon les cas.

Quelques grandes familles se dégagent. L'une d'entre elles dérive notamment des matériaux binaires comme LiNbO₃, LiTaO₃, KNbO₃, KTaO₃ pour aboutir à une formule générale de type ABO₃ où A est constitué d'un ou plusieurs des éléments suivants : Li, Na, K et où B est constitué d'un ou plusieurs des éléments suivants : Nb, Ta, Sb, V. Une autre grande famille dérive des matériaux SrTiO₃, CaTiO₃, SrTiO₃, PbTiO₃, PbZrO₃ notamment pour aboutir à une formule générale de type ABO₃ où A est constitué d'un ou plusieurs des éléments suivants : Ba, Ca, Sr, Mg, Pb, La, Y et où B est constitué d'un ou plusieurs des éléments suivants : Ti, Zr, Sn. D'autres familles moins répandues peuvent également se décliner à partir de BiFeO₃, ou encore LaMnO₃, BaMnO₃, SrMnO₃, ou encore LaAlO3, ou encore, LiAlO₃, LiGaO₃, ou encore CaSiO₃, FeSiO₃, MgSiO₃, ou encore DyScO₃, GdScO₃ et TbScO₃.

Au final, on pourra résumer en considérant que A est constitué d'un ou plusieurs des éléments suivants parmi : Li, Na, K, Ca, Mg, Ba, Sr, Pb, La, Bi, Y, Dy, Gd, Tb, Ce, Pr, Nd, Sm, Eu, Ho, Zr, Sc, Ag, Tl et B est constitué d'un ou plusieurs des éléments suivants parmi : Nb, Ta, Sb, Ti, Zr, Sn, Ru, Fe, V, Sc, C, Ga, Al, Si, Mn, Zr, Tl.

Certains de ces matériaux sont monocristallins ; d'autres ne sont pas monocristallins.

La nature cristalline et la composition du substrat donneur sont choisies par l'homme du métier selon la destination de la couche à transférer.

Le substrat receveur a une fonction de support mécanique de la couche transférée. Il peut être de toute nature et, de manière avantageuse mais non impérative, adaptée à l'application visée, la couche transférée pouvant éventuellement être reportée ultérieurement sur un autre substrat. Le substrat receveur peut être massif ou composite.

Selon un mode de réalisation, l'application du substrat receveur sur le substrat donneur est réalisée par collage.

De manière alternative, l'application du substrat receveur sur le substrat donneur est réalisée par un dépôt du substrat receveur sur le substrat donneur. Toute technique de dépôt adaptée, telle que, par exemple mais de manière non limitative, une évaporation, une pulvérisation cathodique, une pulvérisation aérosol, un dépôt en phase chimique, une électrodéposition, une enduction, un dépôt par centrifugation, un vernissage, une sérigraphie, une immersion, peut être utilisée. Une telle solution est particulièrement avantageuse pour pallier une mauvaise adhésion du substrat donneur vis-à-vis du substrat receveur.

Eventuellement, le procédé comprend la formation d'au moins une couche électriquement isolante et/ou au moins une couche électriquement conductrice (non représentée) à l'interface entre le substrat receveur 110 et la couche 10 à transférer.

Dans le cas où la couche 10 est suffisamment épaisse pour lui conférer une certaine tenue mécanique, notamment lors de l'opération de détachement le long de la zone de fragilisation ou lors de son utilisation ultérieure, l'étape d'application du substrat receveur peut être omise. La couche 10 est alors dite autoportée après son détachement du reste du substrat donneur. Dans ce cas, l'épaisseur de la couche 10 est typiquement supérieure à 2 µm de préférence supérieure à 20 µm, et l'énergie d'implantation des espèces ioniques est supérieure à 1 MeV.

Que la couche 10 de composition initiale ABO₃ soit autoportée ou transférée sur le substrat receveur 110, elle est ensuite convertie en une couche de composition AA'BO₃ où A' est un élément appartenant à la même liste que A mais qui est différent de l'élément A.

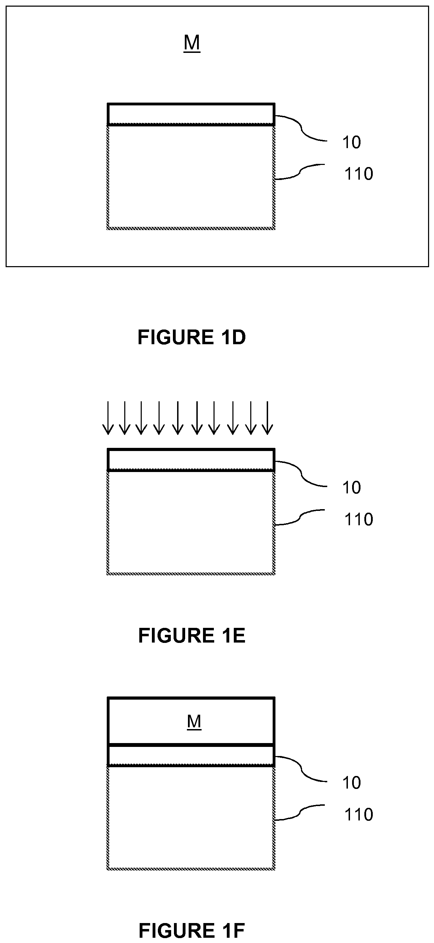

Cette modification de la composition de la couche transférée 10 est effectuée en exposant ladite couche (et éventuellement l'ensemble du substrat receveur qui la supporte) à un milieu M comprenant des ions de l'élément A' (cf. figure 1D).

Cette exposition a pour effet de faire migrer des ions de l'élément A' du milieu M vers la couche transférée 10, enrichissant ainsi la couche transférée en élément A'.

Eventuellement, des atomes de l'élément A situés dans la couche 10 peuvent migrer vers le milieu M.

De même, si l'obtention de la couche 10 a nécessité la mise en oeuvre d'une implantation d'ions H+, des atomes d'hydrogène présents dans la couche transférée à l'emplacement d'atomes de l'élément A, lesdits atomes d'hydrogène peuvent migrer vers le milieu M. Un mécanisme du type échange protonique inverse est mis en jeu dans cette migration. L'échange protonique inverse est décrit, en lien avec une toute autre application que celle adressée par la présente invention, dans l'article de Yu. N. Korkishko et al intitulé « Reverse proton exchange for buried waveguides in LiNbO3 », J. Opt. Soc. Am. A, Vol. 15, No. 7, July 1998.

Selon un mode de réalisation, la couche 10 est exposée au milieu M avant l'étape d'amincissement du substrat donneur et présente ainsi une composition AA'BO₃ avant d'être transférée sur le substrat receveur ou d'être formée en tant que couche autoportée, le cas échéant.

Eventuellement, l'exposition au milieu M peut être mise en oeuvre à la fois avant et après l'amincissement du substrat donneur.

Par ailleurs, on peut insérer différents éléments A' dans la couche 10, en exposant successivement ladite couche à différents milieux comprenant chacun des ions de l'élément A'. On peut ainsi obtenir une couche 10 présentant une composition complexe avec plusieurs éléments de la liste à laquelle appartient l'élément A.

Un mécanisme du type échange ionique est mis en jeu dans la migration des ions de l'élément A' vers la couche de composition initiale ABO₃.

Le milieu M peut être un liquide, auquel cas la couche transférée est immergée dans un bain dudit liquide.

De manière alternative, le milieu M peut être gazeux, auquel cas la couche transférée est placée dans une enceinte contenant ledit gaz.

L'homme du métier est à même de définir les conditions opératoires de cette exposition, notamment la composition du milieu, la durée et la température d'exposition, en fonction de la composition de la couche souhaitée.

Selon un mode de réalisation particulier, illustré sur la figure 1E, l'exposition au milieu peut être réalisée par implantation d'ions de l'élément A' dans la couche transférée (cette implantation est schématisée par les flèches). L'implantation se traduisant par un pic d'ions implantés à une profondeur déterminée de la couche, elle doit être suivie d'un traitement thermique destiné à provoquer une diffusion desdits ions dans l'ensemble de l'épaisseur de la couche, afin d'homogénéiser la composition de celle-ci. Un tel recuit permet également de réparer les défauts cristallins créés par l'implantation. Ce recuit est généralement effectué immédiatement après l'implantation. Dans certains cas, il commence pendant l'étape d'implantation elle-même, notamment lorsque le substrat soumis à l'implantation s'échauffe sous l'exposition du flux d'énergie correspondant. Mais le recuit peut aussi avoir lieu plus tard dans l'enchainement d'étapes de procédés. On peut ainsi intercaler entre l'étape d'implantation et l'étape de recuit d'autres étapes, comme par exemple, l'enlèvement d'une couche superficielle de passivation, ou encore une étape de polissage, une étape de gravure ou encore une opération de transfert de couche. Le recuit peut par ailleurs être effectué en plusieurs fois, qui peuvent être distribuées à différentes étapes du procédé global. L'implantation peut être de type classique, c'est-à-dire dans laquelle les ions sont transportés sous la forme d'un faisceau d'ions accélérés à une certaine énergie (typiquement plusieurs dizaines à plusieurs centaines de keV). En variante, l'implantation peut être effectuée par immersion plasma, qui permet d'implanter rapidement une forte dose d'ions A' au voisinage de la surface de la couche transférée. Ces techniques sont connues de l'homme du métier.

Selon une autre alternative, le milieu M peut être en phase solide, et la couche transférée 10 est exposée audit milieu par dépôt d'une couche dudit milieu sur la couche 10 (cf. figure 1F). Par « sur » on entend ici soit directement en contact avec ladite couche 10, soit par l'intermédiaire d'une ou plusieurs couches formées de matériaux différents, dans la mesure où lesdites couches intermédiaires ne bloquent pas la migration de l'élément A' de la couche constituant le milieu M vers la couche 10. Une meilleure pénétration des ions de l'élément A dans la couche 10 est rendue possible par une ou plusieurs étapes de recuit. La couche déposée contenant l'élément A peut être retirée à la fin de l'opération, éventuellement entre deux étapes de recuits successives.

On prend pour exemple dans la suite du texte une couche de composition initiale LiXO₃, où X est du niobium et/ou du tantale. En d'autres termes, dans cet exemple non limitatif, l'élément A est du lithium et l'élément B est du niobium et/ou du tantale, étant entendu que l'homme du métier est à même de définir les conditions adéquates pour les autres matériaux cités plus haut.

Pour transformer la couche de composition initiale LiXO₃ en une couche de composition LiKXO₃ ou LiNaXO₃, on expose ladite couche à une solution acide d'un sel de potassium ou de sodium.

L'homme du métier est à même de définir les conditions opératoires de cette exposition, notamment la composition du milieu, la durée et la température d'exposition, en fonction de la composition visée pour de la couche transférée.

Eventuellement, avant l'étape d'enrichissement en élément A', on retire une partie de l'épaisseur de la couche transférée sur le substrat receveur. Ce retrait peut être réalisé par polissage mécano-chimique, par gravure ou par toute autre technique appropriée.

On décrit ci-après deux applications de la couche 10 de composition modifiée selon l'invention.

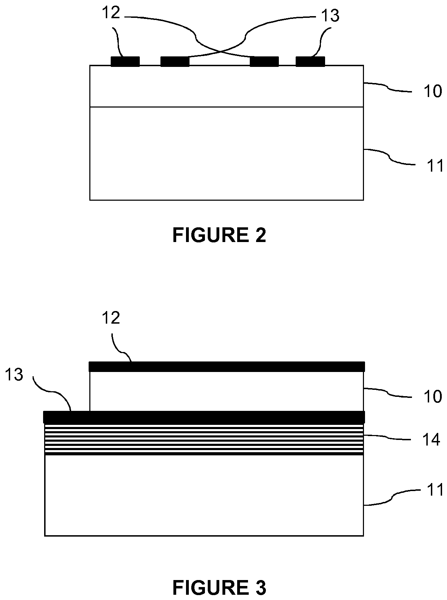

La figure 2 est une vue de principe d'un filtre à ondes acoustiques de surface.

Ledit filtre comprend une couche piézoélectrique 10 et deux électrodes 12, 13 sous la forme de deux peignes métalliques interdigités déposés sur la surface de ladite couche piézoélectrique. Du côté opposé aux électrodes 12, 13, la couche piézoélectrique repose sur un substrat support 11. La couche piézoélectrique 10 est monocristalline, une excellente qualité cristalline étant en effet nécessaire pour ne pas engendrer d'atténuation de l'onde de surface.

La figure 3 est une vue de principe d'un résonateur à ondes acoustiques de volume.

Le résonateur comprend une couche piézoélectrique mince (c'est-à-dire d'épaisseur généralement inférieure à 1 µm, de préférence inférieure à 0,2 µm) et deux électrodes 12, 13 agencées de part et d'autre de ladite couche piézoélectrique 10. La couche piézoélectrique 10 repose sur un substrat support 11. Pour isoler le résonateur du substrat et éviter ainsi la propagation des ondes dans le substrat, un miroir de Bragg 14 est interposé entre l'électrode 13 et le substrat 11. De manière alternative (non illustrée), cette isolation pourrait être réalisée en ménageant une cavité entre le substrat et la couche piézoélectrique. Ces différentes dispositions sont connues de l'homme du métier et ne seront donc pas décrites en détail dans le présent texte.

Dans certains cas, le substrat receveur peut ne pas être optimal pour l'application finale. Il peut alors être avantageux de transférer la couche 10 sur un substrat final (non représenté) dont les propriétés sont choisies en fonction de l'application visée, en la collant sur ledit substrat final et en retirant le substrat receveur par toute technique adaptée.

Dans le cas où l'on souhaite fabriquer un dispositif à ondes acoustiques de surface, on dépose, sur la surface de la couche 10 opposée au substrat receveur 110 ou, le cas échéant, au substrat final (qu'il s'agisse du substrat receveur 110 ou du substrat final 111, ledit substrat forme le substrat support noté 11 sur la figure 2), des électrodes métalliques 12, 13 sous la forme de deux peignes interdigités.

Dans le cas où l'on souhaite fabriquer un dispositif à ondes acoustiques de volume, une adaptation du procédé décrit ci-dessus doit être effectuée. D'une part, on dépose, avant l'étape de collage illustrée sur la figure 1B, une première électrode sur la surface libre de la couche 10 à transférer du substrat donneur, cette première électrode (référencée 13 sur la figure 3) se trouvant enterrée dans l'empilement final. Après l'étape de transfert illustrée sur la figure 1C, on dépose une seconde électrode (référencée 12 sur la figure 3) sur la surface libre de la couche 10, opposée à la première électrode. Une autre option est de transférer la couche 10 sur un substrat final comme mentionné plus haut et de former les électrodes avant et après ledit transfert. D'autre part, pour éviter la propagation des ondes acoustiques dans le substrat receveur 110, on peut intégrer à celui-ci un moyen d'isolation pouvant être, par exemple, un miroir de Bragg (comme illustré sur la figure 3) ou une cavité préalablement gravée dans le substrat receveur ou dans le substrat final le cas échéant.

Enfin, il va de soi que les exemples que l'on vient de donner ne sont que des illustrations particulières en aucun cas limitatives quant aux domaines d'application de l'invention.

### REFERENCES

W. Steichen et S. Ballandras, Composants acoustiques utilisés pour le filtrage - Revue des différentes technologies, Techniques de l'Ingénieur, E2000, 2008
Yu. N. Korkishko et al, Reverse proton exchange for buried waveguides in LiNbO3, J. Opt. Soc. Am. A, Vol. 15, No. 7, July 1998

## Revendications

1. Procédé de fabrication d'une couche de composition AA'BO₃ où A est constitué d'au moins un élément parmi : Li, Na, K, Ca, Mg, Ba, Sr, Pb, La, Bi, Y, Dy, Gd, Tb, Ce, Pr, Nd, Sm, Eu, Ho, Zr, Sc, Ag, Tl et B est constitué d'au moins un élément parmi : Nb, Ta, Sb, Ti, Zr, Sn, Ru, Fe, V, Sc, C, Ga, Al, Si, Mn, Zr, Tl, **caractérisé en ce qu'**il comprend :
- la fourniture d'un substrat donneur (100) de composition ABO₃,
- la formation d'une couche (10) de composition ABO₃ par amincissement dudit substrat donneur (100),
- avant et/ou après l'étape d'amincissement, l'exposition de ladite couche (10) de composition ABO₃ à un milieu (M) contenant des ions d'un élément A' faisant partie de la même liste d'éléments que A, A' étant différent de A, de sorte à faire pénétrer lesdits ions dans ladite couche (10) pour former une couche de composition AA'BO₃.

2. Procédé selon la revendication 1, dans lequel les ions de l'élément A' pénètrent dans la couche (10) par un mécanisme d'échange ionique.

3. Procédé selon l'une des revendications 1 ou 2, dans lequel le milieu (M) contenant les ions de l'élément A' est un liquide et la couche (10) est immergée dans un bain dudit liquide.

4. Procédé selon l'une des revendications 1 à 3, dans lequel la couche (10) de composition ABO₃ est immergée dans un bain comprenant une solution acide d'un sel comprenant l'élément A'.

5. Procédé selon l'une des revendications 1 ou 2, dans lequel le milieu (M) contenant les ions de l'élément A' est en phase gazeuse et la couche (10) est exposée audit gaz.

6. Procédé selon l'une des revendications 1 ou 2, dans lequel le milieu (M) contenant les ions de l'élément A' est en phase solide, une couche dudit milieu (M) étant déposée sur la couche (10).

7. Procédé selon la revendication 6, comprenant au moins une étape de recuit pour favoriser la diffusion de l'élément A' du milieu (M) vers la couche (10).

8. Procédé selon la revendication 1, dans lequel les ions de l'élément A' pénètrent dans la couche (10) par implantation).

9. Procédé selon la revendication 8, comprenant en outre au moins une étape de traitement thermique pour faire diffuser les ions implantés dans la couche (10).

10. Procédé selon l'une des revendications 1 à 9, dans lequel la couche (10) est monocristalline.

11. Procédé selon l'une des revendications 1 à 10, dans lequel l'amincissement du substrat donneur (100) comprend l'application d'un substrat receveur (110) sur le substrat donneur (10), la couche (10) étant à l'interface, et le transfert de la couche (10) sur le substrat receveur (110).

12. Procédé selon la revendication 11, dans lequel l'application du substrat receveur comprend le dépôt dudit substrat (110) sur le substrat donneur (100).

13. Procédé selon la revendication 11, dans lequel l'application du substrat receveur comprend le collage dudit substrat (110) sur le substrat donneur (100).

14. Procédé selon l'une des revendications 11 à 13, dans lequel l'épaisseur de la couche (10) est inférieure à 20 µm.

15. Procédé selon l'une des revendications 11 à 14, dans lequel on forme au moins une couche électriquement isolante et/ou au moins une couche électriquement conductrice à l'interface entre le substrat receveur (110) et la couche (10).

16. Procédé selon l'une des revendications 1 à 10, dans lequel l'épaisseur de la couche (10) est supérieure à 2 µm, de préférence supérieure à 20 µm, ladite couche étant autoportée à l'issue de l'amincissement du substrat donneur (100).

17. Procédé selon la revendication 11, dans lequel l'amincissement du substrat donneur (10) comprend les étapes suivantes :
- la formation d'une zone de fragilisation (101) dans le substrat donneur (100) de sorte à délimiter la couche (10) de composition ABO₃,
- le détachement du substrat donneur (100) le long de la zone de fragilisation (101).

18. Procédé selon la revendication 17, dans lequel la zone de fragilisation (101) est formée par implantation ionique dans le substrat donneur (100).

19. Procédé selon l'une des revendications 1 à 18, dans lequel A est du lithium et l'élément A' est du sodium et/ou du potassium.

20. Procédé selon la revendication 19, dans lequel l'élément B est du niobium et/ou du tantale.

21. Procédé de fabrication d'un dispositif à ondes acoustiques de volume, comprenant la formation d'électrodes (12, 13) sur deux faces principales opposées d'une couche piézoélectrique (10), **caractérisé en ce qu'**il comprend la fabrication de ladite couche piézoélectrique (10) par un procédé selon l'une des revendications 1 à 20.

22. Procédé de fabrication d'un dispositif à ondes acoustiques de surface, comprenant la formation de deux électrodes (12, 13) interdigitées sur la surface d'une couche piézoélectrique (10), **caractérisé en ce qu'**il comprend la fabrication de ladite couche piézoélectrique par un procédé selon l'une des revendications 1 à 20.

## Patentansprüche

1. Verfahren zur Herstellung einer Schicht mit einer Zusammensetzung AA'BO₃, wobei A aus mindestens einem Element gebildet wird aus: Li, Na, K, Ca, Mg, Ba, Sr, Pb, La, Bi, Y, Dy, Gd, Tb, Ce, Pr, Nd, Sm, Eu, Ho, Zr, Sc, Ag, Tl und B aus mindestens einem Element gebildet wird aus: Nb, Ta, Sb, Ti, Zr, Sn, Ru, Fe, V, Sc, C, Ga, Al, Si, Mn, Zr, Tl, **dadurch gekennzeichnet, dass** es Folgendes umfasst:
- Bereitstellen eines Spendersubstrats (100) einer Zusammensetzung ABO₃,
- Bilden einer Schicht (10) einer Zusammensetzung durch ABO₃ durch Ausdünnen des Spendersubstrats (100),
- vor und/oder nach dem Schritt des Ausdünnens, Aussetzen der Schicht (10) einer Zusammensetzung ABO₃ einem Milieu (M), das Ionen eines Elements A' enthält, das zur selben Liste an Elementen wie A gehört, wobei sich A' von A unterscheidet, um die Ionen in die Schicht (10) eindringen zu lassen, um eine Schicht einer Zusammensetzung AA'BO₃ zu bilden.

2. Verfahren nach Anspruch 1, wobei die Ionen des Elements A' durch einen Ionenaustauschmechanismus in die Schicht (10) eindringen.

3. Verfahren nach einem der Ansprüche 1 oder 2, wobei das Milieu (M), das die Ionen des Elements A' enthält, eine Flüssigkeit ist und die Schicht (10) in ein Bad der Flüssigkeit eingetaucht wird.

4. Verfahren nach einem der Ansprüche 1 bis 3, wobei die Schicht (10) einer Zusammensetzung ABO₃ in ein Bad eingetaucht wird, das eine saure Lösung eines Salzes umfasst, das das Element A' umfasst.

5. Verfahren nach einem der Ansprüche 1 oder 2, wobei das Milieu (M), das die Ionen des Elements A' enthält, in einer gasförmigen Phase ist und die Schicht (10) dem Gas ausgesetzt wird.

6. Verfahren nach einem der Ansprüche 1 oder 2, wobei das Milieu (M), das die Ionen des Elements A' enthält, in einer festen Phase ist, wobei eine Schicht des Milieus (M) auf der Schicht (10) abgeschieden wird.

7. Verfahren nach Anspruch 6, umfassend mindestens einen Ausglühschritt umfassend, um die Diffusion des Elements A' des Milieus (M) zur Schicht (10) zu fördern.

8. Verfahren nach Anspruch 1, wobei die Ionen des Elements A' durch Implantieren in die Schicht (10) eindringen.

9. Verfahren nach Anspruch 8, weiter mindestens einen Schritt einer Wärmebehandlung umfassend, um die in die Schicht (10) implantierten Ionen diffundieren zu lassen.

10. Verfahren nach einem der Ansprüche 1 bis 9, wobei die Schicht (10) einkristallin ist.

11. Verfahren nach einem der Ansprüche 1 bis 10, wobei die Ausdünnung des Spendersubstrats (100) das Anwenden eines Empfängersubstrats (110) auf dem Spendersubstrat (10), wobei die Schicht (10) an der Schnittstelle ist, und den Transfer der Schicht (10) auf das Empfängersubstrat (110) umfasst.

12. Verfahren nach Anspruch 11, wobei das Anwenden des Empfängersubstrats das Abscheiden des Substrats (110) auf dem Spendersubstrat (100) umfasst.

13. Verfahren nach Anspruch 11, wobei das Anwenden des Empfängersubstrats das Kleben des Substrats (110) auf das Spendersubstrat (100) umfasst.

14. Verfahren nach einem der Ansprüche 11 bis 13, wobei die Dicke der Schicht (10) geringer als 20 µm ist.

15. Verfahren nach einem der Ansprüche 11 bis 14, wobei mindestens eine elektrisch isolierende Schicht und/oder mindestens eine elektrisch leitende Schicht an der Schnittstelle zwischen dem Empfängersubstrat (110) und der Schicht (10) gebildet wird.

16. Verfahren nach einem der Ansprüche 1 bis 10, wobei die Dicke der Schicht (10) größer als 2 µm, vorzugsweise größer als 20 µm ist, wobei die Schicht am Ende des Ausdünnens des Spendersubstrats (100) selbsttragend ist.

17. Verfahren nach Anspruch 11, wobei das Ausdünnen des Spendersubstrats (10) die folgenden Schritte umfasst:
- das Bilden einer Schwächungszone (101) in dem Spendersubstrat (100), um die Schicht (10) einer Zusammensetzung ABO₃ zu begrenzen,
- das Loslösen des Spendersubstrats (100) entlang der Schwächungszone (101).

18. Verfahren nach Anspruch 17, wobei die Schwächungszone (101) durch ionisches Implantieren in das Spendersubstrat (100) gebildet wird.

19. Verfahren nach einem der Ansprüche 1 bis 18, wobei A Lithium ist und das Element A' Natrium und/oder Kalium ist.

20. Verfahren nach Anspruch 19, wobei das Element B Niob und/oder Tantal ist.

21. Verfahren zur Herstellung einer akustischen Volumenwellenvorrichtung, umfassend die Bildung von Elektroden (12, 13) an zwei entgegengesetzten Hauptseiten einer piezoelektrischen Schicht (10), **dadurch gekennzeichnet, dass** es die Herstellung der piezoelektrischen Schicht (10) durch ein Verfahren nach einem der Ansprüche 1 bis 20 umfasst.

22. Verfahren zur Herstellung einer akustischen Oberflächenwellenvorrichtung, umfassend die Bildung von Elektroden (12, 13), die an der Oberfläche einer piezoelektrischen Schicht (10) interdigitiert sind, **dadurch gekennzeichnet, dass** es die Herstellung der piezoelektrischen Schicht durch ein Verfahren nach einem der Ansprüche 1 bis 20 umfasst.

## Claims

1. Method for producing a layer of composition AA'BO₃ where A consists of at least one element selected from: Li, Na, K, Ca, Mg, Ba, Sr, Pb, La, Bi, Y, Dy, Gd, Tb, Ce, Pr, Nd, Sm, Eu, Ho, Zr, Sc, Ag, Tl and B consists of at least one element selected from: Nb, Ta, Sb, Ti, Zr, Sn, Ru, Fe, V, Sc, C, Ga, Al, Si, Mn, Zr, Tl, **characterised in that** it comprises:
- providing a donor substrate (100) of composition ABO₃,
- forming a layer (10) of composition ABO₃ by thinning said donor substrate (100),
- before and/or after the thinning step, exposing said layer (10) of composition ABO₃ to a medium (M) containing ions of an element A' belonging to the same list of elements as A, A' being different from A, such that said ions penetrate into said layer (10) to form a layer of composition AA'BO₃.

2. Method according to claim 1, in which the ions of the element A' penetrate into the layer (10) by an ion exchange mechanism.

3. Method according to one of claims 1 or 2, in which the medium (M) containing the ions of the element A' is a liquid and the layer (10) is immersed in a bath of said liquid.

4. Method according to one of claims 1 to 3, in which the layer (10) of composition ABO₃ is immersed in a bath comprising an acid solution of a salt comprising the element A'.

5. Method according to one of claims 1 or 2, in which the medium (M) containing the ions of the element A' is in gaseous phase and the layer (10) is exposed to said gas.

6. Method according to one of claims 1 or 2, in which the medium (M) containing the ions of the element A' is in solid phase, a layer of said medium (M) being deposited on the layer (10).

7. Method according to claim 6, comprising at least one annealing step to favour the diffusion of the element A' from the medium (M) to the layer (10).

8. Method according to claim 1, in which the ions of the element A' penetrate into the layer (10) by implantation.

9. Method according to claim 8, further comprising at least one heat treatment step to make the implanted ions diffuse into the layer (10).

10. Method according to one of claims 1 to 9, in which the layer (10) is monocrystalline.

11. Method according to one of claims 1 to 10, in which the thinning of the donor substrate (100) comprises the application of a receiver substrate (110) on the donor substrate (10), the layer (10) being at the interface, and the transfer of the layer (10) onto the receiver substrate (110).

12. Method according to claim 11, in which the application of the receiver substrate comprises the deposition of said substrate (110) on the donor substrate (100) .

13. Method according to claim 11, in which the application of the receiver substrate comprises the bonding of said substrate (110) on the donor substrate (100) .

14. Method according to one of claims 11 to 13, in which the thickness of the layer (10) is less than 20 µm.

15. Method according to one of claims 11 to 14, in which at least one electrically insulating layer and/or at least one electrically conducting layer is formed at the interface between the receiver substrate (110) and the layer (10).

16. Method according to one of claims 1 to 10, in which the thickness of the layer (10) is greater than 2 µm, preferably greater than 20 µm, said layer being self-supporting at the end of the thinning of the donor substrate (100).

17. Method according to claim 11, in which the thinning of the donor substrate (10) comprises the following steps:
- the formation of a weakened zone (101) in the donor substrate (100) so as to delineate the layer (10) of composition ABO₃,
- the detachment from the donor substrate (100) along the weakened zone (101).

18. Method according to claim 17, in which the weakened zone (101) is formed by ion implantation in the donor substrate (100).

19. Method according to one of claims 1 to 18, in which A is lithium and the element A' is sodium and/or potassium.

20. Method according to claim 19, in which the element B is niobium and/or tantalum.

21. Method for producing a bulk acoustic wave device, comprising forming electrodes (12, 13) on two opposite main faces of a piezoelectric layer (10), **characterised in that** it comprises the production of said piezoelectric layer (10) by a method according to one of claims 1 to 20.

22. Method for producing a surface acoustic wave device, comprising the formation of two interdigitated electrodes (12, 13) on the surface of a piezoelectric layer (10), **characterised in that** it comprises the production of said piezoelectric layer by a method according to one of claims 1 to 20.
